# EUROPÄISCHE PATENTSCHRIFT

(11) **EP 2 831 914 B1**
(45) Veröffentlichungstag und Bekanntmachung des Hinweises auf die Patenterteilung: **21.11.2018**
(21) Anmeldenummer: 13718075.8
(22) Anmeldetag: 28.03.2013
(51) Int. Cl.: H01L 27/142, H01L 31/0352, H01L 31/0392, H01L 31/0463, H01L 31/18, H01L 31/20, H01L 31/0224

(54) **HERSTELLUNGSVERFAHREN STRUKTURIERTER DÜNNSCHICHT PHOTOVOLTAIK**
METHOD FOR PRODUCING STRUCTURED THIN-LAYER PHOTOVOLTAICS
PROCÉDÉ DE FABRICATION DE CELLULES PHOTOVOLTAÏQUES À COUCHE MINCE STRUCTURÉES

(30) Priorität: 30.03.2012 AT 3912012
(43) Veröffentlichungstag der Anmeldung: 04.02.2015
(73) Patentinhaber: AIT Austrian Institute of Technology GmbH, 1220 Wien (AT)
(72) Erfinder: RENNHOFER, Marcus, A-1200 Wien (AT); BERGER, Karl Anton, A-2511 Pfaffstätten (AT)
(74) Vertreter: Wildhack & Jellinek
(86) Internationale Anmeldenummer: PCT/AT2013/050077
(87) Internationale Veröffentlichungsnummer: WO 2013/142891

(56) Entgegenhaltungen:
- EP-A2- 2 282 352
- EP-A2- 2 423 980
- WO-A1-2009/121180
- JP-A- H06 177 408
- US-A1- 2006 266 407
- US-A1- 2011 023 957

## Beschreibung

Die Erfindung betrifft ein neues Verfahren zur Herstellung von monolithisch verschalteten photovoltaischen Dünnschicht-Zellen und damit gebildeten, stromliefernden Modulen, und zwar auf rein physikalischem Wege ausschließlich durch gerichtete Abscheidung des dafür vorgesehenen Materials auf einer strukturierten Oberfläche.

### Stand der Technik:

Der Stand der Technik auf dem Gebiet der Herstellung von Dünnschicht-Solar- bzw. Photovoltaik(PV)-Zellen und -Modulen besteht in der Deposition, also Abscheidung der halbleitenden "Elemente" und der elektrisch leitenden Verbindungen, meist Metalle oder, insbesondere transparente, leitende Oxide (TCO) gemäß "Substrattechnik" auf einem Substratmaterial, also auf einem Untergrund, der danach vorderseitig lichtdurchlässig verkapselt wird oder gemäß "Superstrattechnik", wobei die Zellen und die Verbinder auf der Rückseite eines lichtdurchlässigen Mediums aufgebracht wird, das dann von hinten verkapselt wird.

Wesentlich dabei ist, dass die PV-Zellen und die elektrischen Verbindungen zwischen denselben bisher mittels eines mehrfache, schrittweise aufeinander folgende Abscheidungs- und Laserstrukturierungsprozessschritte umfassenden Verfahrens hergestellt werden mussten.

Möglich sind gemäß dem Stand der Technik auch weitere bzw. andere Prozessschritte, wie z.B. zur Dotierung, beispielsweise durch Plasmadeposition oder durch den Einsatz von Diffusionsöfen.

Die Verschaltung der einzelnen PV-Elemente bzw. der PV-Zellen erfolgt im Zuge des Bedampfungsprozesses und es gibt letztlich keine weiteren, gesonderten elektrischen Verbinder, wie z.B. leitende Drähte oder Lötbändchen, was als "monolithisch" bezeichnet wird.

Zum bestehenden Stand der Technik sei beispielhaft auf US 2010239747 A1, US 2011139209 A1, DE 102009044323 A1, DE 102008041059 A1, DE 102006002430 A1, KR 20090126708 A und KR 200440080568 A hingewiesen.

*Aus der* EP 2 423 980 *ist ein Verfahren zur Herstellung* - *von mit untereinander in jeweils gewünschter oder technisch bedingter Weise verschalteten Einzel-Dünnschicht-Photovoltaikelementen gebildeten* - *Photovoltaikzellen bzw. -modulen durch gerichtete Abscheidung der zur Bildung der eben genannten Einzelphotovoltaikelemente einzusetzenden Materialien bekannt, wobei, unter kontinuierlicher Aufrechterhaltung einer jeweils vorgesehenen Gasatmosphäre oder eines Vakuums bzw. Unterdrucks während des gesamten Herstellungs- bzw. Abscheidungsprozesses, also unter Vermeidung von Aussetzperioden -*
*i) auf eine große Zahl von, nach einer oder mehr als einer, vorzugsweise einheitlichen, Richtung(en) hin ausgerichteten, positiven Teilbereichsflächen einer dreidimensional strukturierten Oberfläche eines plattenförmigen, vorzugsweise elektrisch nicht leitenden, Substratmaterials unter strukturell bedingter Abschattung der jeweils die genannten positiven Teilbereichsflächen verbindenden und in im Wesentlichen entgegengesetzter Richtung ausgerichteten, negativen Verbindungs-Teilbereichsflächen unter einem, gegebenenfalls rechten, Winkel ein Materiegas- oder Flüssigkeitsdruckstrahl oder -strom aus einem Elektro-Kontaktmaterial zur Bildung bzw. Abscheidung der Rückseiten-Kontakte der Einzel-Photovoltaikelemente gerichtet wird,*
*ii) dann auf den* - *auf den wie unter i) genannten Teilbereichsflächen abgeschiedenen* - *Rückseitenkontakten, mittels anders, also unterschiedlich, beaufschlagter Materiegas- oder Flüssigkeitsdruckstrahl oder -ströme eine jeweils für die Bildung der stromliefernden photovoltaisch aktiven Schichten der Einzel-Photovoltaikelemente vorgesehene Zell-Architektur aufgebracht bzw. abgeschieden wird, und*
*iii) schließlich auf die Außenflächen der unter ii) genannten photovoltaisch aktiven Schichten der Einzel-Photovoltaikelemente jeweils unter Anbindung an die abgeschiedenen Rückseitenkontakten* - *ein Materiegas- oder Flüssigkeitsdruckstrahl oder -strom aus einem für die Bildung bzw. Abscheidung der Frontkontakte vorgesehenen Elektro-Kontaktmaterial der Einzel-Photovoltaikelemente gerichtet wird.*

### Vor- und Nachteile des Stands der Technik:

Vorteile des bestehenden Standes der Technik sind insbesondere folgende: Es gibt keine weiteren gesonderten elektrischen Verbinder, die benötigten Materialmengen sind sehr gering, die stromliefernden Dünnschichtelemente sind z.B. bloß 1µm bis 10µm dick, im Unterschied zu kristallinen Zellen mit Dicken ab ca. 100µm.

Die Prozesstemperaturen sind gering, es ist keine Siliziumschmelze und/oder Reinigung mittels Zonenschmelzen nötig.

Die Vorteile liegen also in den relativ geringen Herstellungskosten durch geringe Materialkosten und relativ geringe Energiekosten.

Ganz wesentliche generelle Nachteile der Dünnschichttechnologie gemäß dem Stand der Technik sind insbesondere die notwendigerweise ganz präzise Bearbeitungstechnologie, weiters dass einzelne Prozessschritte im Vakuum stattfinden müssen und die Bedampfungsschritte durch die zwingend erforderlichen Laserstrukturierungsprozesse - üblich sind drei derartige Laserschritte - unterbrochen werden müssen.

Dies erfordert ein mehrmaliges Evakuieren der Produktionsanlage und/oder ein mehrmaliges, jedenfalls sehr genaues Positionieren des Substrates auf der Prozessstrasse. Die damit erkauften Nachteile sind insbesondere höhere Prozesskosten und - infolge des mehrmalig notwendigen Wechsels zwischen Abschalten und WiederEinschalten des Vakuums oder einer jeweils gewählten Atmosphäre - längere Prozesszeiten, als ohne diese Schritte.

### Die Erfindung:

Gegenstand dieser Erfindung ist ein neues Verfahren zur Herstellung - von mit untereinander in jeweils gewünschter oder technisch bedingter Weise verschalteten Einzel-Dünnschicht-Photovoltaikelementen gebildeten - Photovoltaikzellen bzw. -modulen durch gerichtete Abscheidung der zur Bildung der eben genannten Einzelphotovoltaikelemente einzusetzenden Materialien, welches **dadurch gekennzeichnet** ist,
- dass unter kontinuierlicher Aufrechterhaltung einer jeweils vorgesehenen Gasatmosphäre oder eines Vakuums bzw. Unterdrucks während des gesamten Herstellungs- bzw. Abscheidungsprozesses, also unter Vermeidung von Aussetzperioden,
   a) auf eine große Zahl von, nach einer oder mehr als einer, vorzugsweise einheitlichen, Richtung(en) hin ausgerichteten, positiven Teilbereichsflächen einer drei-dimensional strukturierten Oberfläche eines plattenförmigen, vorzugsweise elektrisch nicht leitenden, Substratmaterials unter strukturell bedingter Abschattung der jeweils die genannten positiven Teilbereichsflächen verbindenden und in entgegengesetzter Richtung ausgerichteten, negativen Verbindungs-Teilbereichsflächen unter einem, gegebenenfalls rechten, Winkel ein Materiegas- oder Flüssigkeitsdruckstrahl oder -strom aus einem Elektro-Kontaktmaterial zur Bildung bzw. Abscheidung der Rückseiten-Kontakte der Einzel-Photovoltaikelemente gerichtet wird,
   b) dass auf einen oberen Bereich der gemäß a) genannten abgeschatteten - in anderer oder in entgegengesetzter Richtung als die *oder zu den* unter a) genannten Teilbereichsflächen in Richtung ausgerichteten - Verbindungs-Teilbereichsflächen unter einem Winkel, gegebenenfalls >90°, ein Materiegas- oder Flüssigkeitsdruckstrahl eines, gegebenenfalls dem Elektro-Kontaktmaterial gemäß a) gleichen, Elektro-Kontaktmaterials unter Abscheidung von die unter a) genannten Rückseiten-Kontakte miteinander elektrisch verbindenden, stromleitenden Zell-Verbindern aufgebracht wird,
   c) dass dann unter (Wieder-)Einstellung der unter a) eingehaltenen Materiegas- oder Flüssigkeitsdruckstrahl- oder -stromrichtung auf den wie unter a) genannten Teilbereichsflächen abgeschiedenen Rückseitenkontakten, mittels anders, also unterschiedlich, beaufschlagter Materiegas- oder Flüssigkeitsdruckstrahl oder -ströme eine jeweils für die Bildung des stromliefernden Kernbereiches der Einzel-Photovoltaikelemente vorgesehene Zell-Architektur aufgebracht bzw. abgeschieden wird, und
   d) dass schließlich unter Beibehaltung der unter a) oder c) genannten Materiegas- oder Flüssigkeitsdruckstrahl- oder -stromrichtung auf die Außenflächen der unter c) genannten Kernbereiche der Einzel-Photovoltaikelemente jeweils unter Anbindung an die mit den gemäß a) abgeschiedenen Rückseitenkontakten elektrisch verbundenen Zellverbinder ein Materiegas- oder Flüssigkeitsdruckstrahl oder -strom aus einem für die Bildung bzw. Abscheidung der Frontkontakte vorgesehenen Elektro-Kontaktmaterial der Einzel-Photovoltaikelemente gerichtet wird.

Der erfindungsgemäße Prozess betrifft also die Herstellung von monolithisch verschalteten photovoltaischen Dünnschichtzellen bzw. von dieselben aufweisenden stromliefernden Photovoltaik-Modulen ausschließlich durch "gerichtete" Material-Abscheidung, insbesondere durch gerichtete Bedampfung oder selektive Richtstrahl-Bedruckung, auf einer strukturierten, mit dreidimensionalen, vorzugsweise regelmäßigen, und regelmäßig angeordneten, Erhebungen geformten Oberfläche eines, bevorzugt elektroneutralen, Materials im Vakuum bzw. bei Unterdruck oder in einer speziellen Atmosphäre, und zwar, ohne das Vakuum bzw. den Unterdruck oder die Atmosphäre unterbrechen zu müssen.

Bei dem neuen Verfahren entfallen alle zwischen den einzelnen Abscheidungsprozessschritten bisher nötig gewesenen Laserstrukturierungsprozessschritte, wodurch man sich alle bei Herstellung gemäß dem Stand der Technik notwendigen, nachfolgenden, immer wieder die mehrmalige Aufhebung des Vakuums oder der Atmosphäre nötig machenden gesonderten Strukturierungsprozesse erspart.

Die Materie-Abscheidung, also die gerichtete Bedampfung oder Bedruckung auf einem Substrat, erfolgt auch gemäß der vorliegenden Erfindung in mehreren Schritten in numerischer Abfolge. Die Schritte erfolgen jeweils nacheinander unter einem jeweils der Topographie der Oberfläche des Substrates entsprechenden Neigungswinkel je Prozessschritt:
Zuerst in einen bestimmten Winkel für die Rückseitenkontakte, in einem weiteren für die Photostrom liefernde Zellarchitektur, in einem weiteren Winkel für die Frontseitenkontakte und schließlich in einem anderen Winkel für die Abscheidung der Zellverbinder, wobei jeweils der Ausdruck "ein Winkel" einen - meist geringen - Winkel-Streubereich einschließt.

Alle diese Abscheidungsschritte können gemäß der Erfindung in ein und demselben Vakuum bzw. Unterdruck oder in einer gleich bleibenden Atmosphäre, ohne dessen bzw. deren Aufhebung oder Unterbrechung erfolgen.

Verbesserungen durch das erfindungsgemäße neue Verfahren gegenüber dem Stand der Technik:
Der erfindungsgemäße Prozess besteht in der Herstellung von monolithisch verschalteten photovoltaischen Dünnschichtelementen und -zellen bzw. -modulen ausschließlich durch gerichtete Abscheidungsprozesse, wie insbesondere durch Strahl-Bedampfung oder Strahl-Bedruckung, und zwar in einer über den gesamten Prozess aufrecht erhalten bleibenden Atmosphäre ohne deren Unterbrechung.

Das Abscheiden, also die gerichtete, topografie-selektive Bedampfung oder Bedruckung auf der mit dreidimensionalen Erhebungen geformten Oberfläche des jeweiligen Substrates unter verschiedenen Winkeln führt jeweils zu einem gezielten Schattenwurf der die selektive Materialabscheidung auf den jeweils vorgesehenen, nicht im Strahl-Schatten der Erhebungen liegenden Teilflächen der Substratstrukturen ermöglicht.

Auf der Substrat-Oberfläche können durch die Wahl des Winkels der gerichteten, mittels eines gerichteten Materiestrahls durchgeführten Abscheidung die Bereiche bzw. Teilflächen für jeden der vorzunehmenden Strukturierungs- oder Abscheidungsschritte präzise gewählt werden, um so die PV-Zellarchitektur bzw. -Zellstruktur und die elektrische Verbindungsarchitektur, auf der strukturierten, mit dreidimensionalen regelmäßigen Erhebungen ausgebildeten Oberfläche des Substrates, meist nacheinander, herzustellen.

Die Abscheidung des jeweiligen Materials, also die Bedampfung oder Bedruckung auf den jeweiligen Teilflächen des Substrates erfolgt in nacheinander folgenden Schritten im Vakuum oder in einer speziellen Atmosphäre, ohne dass das Vakuum oder die Atmosphäre gebrochen werden muss, in numerischer Abfolge.

Die wesentlichen Verbesserungen im Vergleich zu den Verfahren des bekannten Standes der Technik bestehen insbesondere in Folgendem:
Der neue Prozess ermöglicht die Herstellung von einzelnen stromliefernden Solar- bzw. PV-Elementen und damit gebildeten Solar- bzw. PV-Zellen
(a) unter völligem Verzicht auf die bisher unbedingt erforderlichen, das Vakuum oder die gewählte Atmosphäre jeweils unterbrechenden Laserstrukturierungsschritte,
(b) ohne das deswegen bisher notwendige mehrmalige präzise Wieder-Positionieren des Substrates, sodass
(c) der Herstellungsprozess in einer einheitlichen Prozessstrasse kontinuierlich durchgeführt werden kann.
   Wesentlich ist weiters, dass die erfindungsgemäß hergestellten photovoltaischen Elemente, Zellen bzw. Module auf strukturierten Oberflächen von Substraten
(d) wesentlich verbesserte Lichteinkopplungseigenschaften für diffuse Strahlung und eine
(e) "verbesserte" Winkelabhängigkeit, also vielmehr eine erhöhte Winkel-Unabhängigkeit und somit geringere Reflexionsverluste bei direkter Strahlung unter flachen Winkeln, also insbesondere morgens oder abends, aufweisen.
Daher sind mit dem erfindungsgemäßen Verfahren
(i) ein wesentliches Einsparungspotenzial schon bei der Herstellung,
(ii) eine Reduktion der Prozesszeiten bei der Herstellung der neuen Dünnschicht-PV- bzw. -Solarzellen bzw. Photovoltaik-Module und, was ganz wichtig ist,
(iii) ein erhöhter Jahresertrag der PV-Zellen bzw. -Module je Nennleistung zu erreichen.

Der ganz wesentliche Vorteil der erfindungsgemäßen Herstellungstechnik besteht in der erstmalig ermöglichten Produktion von monolithisch verschalteten photovoltaischen Dünnschichtzellen bzw. Modulen, ausschließlich auf physikalischem Wege durch gerichtete Abscheidung, also Bedampfung oder Bedruckung der einzelnen Teilflächen der strukturierten Oberfläche eines Substrates im Vakuum oder in einer Atmosphäre, ohne das- oder dieselbe zu brechen und unter völliger Weglassung aller bisher notwendigen Laserstrukturierungsprozessschritte, wodurch man alle bei Herstellung gemäß dem Stand der Technik zwingend erforderlichen nachfolgenden, gesonderten Strukturierungsprozesse erspart.

Im Rahmen der Erfindung, insbesondere im Hinblick auf die relativ unkomplizierte Fertigung des plattenartigen Substratmaterials ist eine Ausführungsform des Herstellungsprozesses des neuen Photovoltaik-Moduls bevorzugt, gemäß welcher vorgesehen ist, dass als dreidimensional strukturiertes Substratmaterial ein solches eingesetzt wird, dessen Oberfläche mit zueinander parallel angeordneten und zueinander parallel ausgerichtete Kämme und zwischen einander zueinander parallele Täler aufweisenden Dreiecksprismen ausgebildet sind, und dass auf deren alle den gleichen positiven Neigungs-Winkel zur Substraterstreckung aufweisenden zueinander ebenfalls parallel verlaufenden bandartigen, die positiven Teilbereichsflächen bildenden Seitenflächen selbst gemäß a) bzw. auf die auf die Außenflächen der auf die soeben genannte Flächen gemäß c) aufgebrachten Kernbereiche der Einzel-Photovoltaikelemente gemäß d) mittels Materiegas- oder Flüssigkeitsdruckstrahl das Elektrokontaktmaterial aufgebracht wird und dass gemäß b) auf die kamm-nahen bis zu den Prismenkämmen reichenden bandartigen Teilbereiche der ebenfalls zueinander parallel verlaufenden negativen Teilbereichsflächen ebenfalls mittels Materiegas- oder Flüssigkeitsdruckstrahl das Elektrokontaktmaterial aufgebracht ist.

Gemäß zweier relativ einfacher Ausführungsvarianten kann so vorgegangen werden, dass ein Substratmaterial eingesetzt wird, dessen Oberfläche mit untereinander gleiche Dimension besitzenden, gleichseitigen Dreiecks-Querschnitt aufweisenden Dreiecksprismen als Erhebungen ausgebildet ist, oder dass ein Substratmaterial eingesetzt wird, dessen Oberfläche mit untereinander gleiche Dimension besitzenden, verschieden-seitigen Dreiecks-Querschnitt aufweisenden Dreiecksprismen als Erhebungen ausgebildet ist.

Insbesondere für spezielle Formen und Aufgaben des neuen PV-Moduls, z.B. für dessen Einsatz in Photovoltaikfenstern oder -fassaden, ist es von Vorteil, wenn dass ein Substratmaterial eingesetzt wird, dessen die Erhebungen der Oberfläche bildenden Dreiecksprismen jeweils einen Kammwinkel von 60 bis 120°, insbesondere von 80 bis 100°, aufweisen.

Was bevorzugte Ausbildungsformen der topografisch strukturierten Oberfläche des Substratmaterials des neuen PV-Moduls betrifft, so hat sich gezeigt, dass es günstig ist, wenn dass ein Substratmaterial eingesetzt wird, dessen die Erhebungen der Oberfläche bildenden Dreiecksprismen positive Seitenflächen bzw. Teilbereichsflächen zur Erstreckung des Substratmaterials zwischen +90 und +15°, insbesondere zwischen +75 und +30°, bzw. dessen negativen Seitenflächen bzw. Teilbereichsflächen zur Erstreckung des Substrates zwischen -90 und -15° insbesondere zwischen -75 und -30°, geneigt sind.

Herstellungstechnisch einfacher und bei üblichem Gebrauch weniger anfällig sind die neuen PV-Zellen bzw. -Module gemäß der Erfindung, wenn ein Substratmaterial eingesetzt wird, dessen die Erhebungen der Oberfläche bildenden Dreiecksprismen etwa zylindermantelflächig abgerundete Kämme aufweisen.

Zur Vermeidung der Generierung von zu hoher Spannung den von den neuen PV-Aggregaten gelieferten Stroms ist eine Parallelschaltung einer Mehrzahl von jeweils ungefährlichen, also relativ niedrige Spannung liefernden PV-Teilmodulen günstig.

Dem gemäß ist eine Ausführungsvariante des neuen Verfahrens bevorzugt, gemäß welcher ein Substratmaterial eingesetzt wird, dessen Oberfläche mit einer Mehrzahl von jeweils bevorzugt gleiche Anzahl von zueinander parallel verlaufenden Dreiecksprismen untereinander gleicher Dimension, insbesondere gleicher Prismenhöhe, aufweisenden Serien bzw. Paketen von Dreiecksprismen ausgebildet ist, die jeweils voneinander durch Dreiecksprismen mit größerer Dimension, insbesondere größerer Prismenhöhe, getrennt sind.

Nicht zuletzt ist festzuhalten, dass das erfindungsgemäß einsetzbare Substratmaterial keineswegs auf ein solches beschränkt sein muss, dessen Oberfläche mit zueinander parallelen "Streifen" von Dreiecksprismen oder dergleichen ausgebildet ist. So kann, insbesondere für Spezialzwecke, z.B. für erhöhte Lichtausbeute, vorgesehen sein, dass ein Substratmaterial eingesetzt wird, dessen Oberfläche mit untereinander gleiche Dimension besitzenden rasterartig angeordneten, aneinandergrenzenden vier- oder sechsseitigen Pyramiden ausgebildet ist, wobei analog zur Schrittfolge a) bis d) gemäß Anspruch1,
a) zuerst auf die 2 oder 3 positiv angeordneten Pyramidenflächen mittels gasförmigen Materie- oder flüssigdispersem Druckstrahl ein Rückseiten-Elektrokontaktmaterial aufgebracht wird,
b) auf die spitzennahen, oberen Bereiche der negativen Pyramidenflächen und unter Ausschluss der unteren Bereiche derselben in gleicher Weise wie gemäß a) ebenfalls ein Elektrokontakt-Verbindungs-Material aufgebracht wird,
c) dann - analog zu Schritt c) des Anspruches 1 - wieder auf die mit Rückseiten-Elektrokontaktmaterial beaufschlagten positiv angeordneten Pyramidenflächen Photovoltaikelements-Kern-Material und
d) auf dasselbe - analog zu Schnitt d) des Anspruches 1 - das Frontseiten-Elektrokontaktmaterial auf das Photovoltaikelements-Kern-Material der positiven Pyramidenflächen und auf die Schmal- bzw. Stirnseite des Verbindungs-Elektrokontaktmaterials in den spitzen-nahen Bereichen der negativen Pyramidenflächen aufgebracht wird.

### Anhand der Zeichnung wird die Erfindung näher erläutert:

Es zeigen die Fig.1 in einer Perspektivansicht ein, z.B. aus Glas gefertigtes, plattenförmiges Substratmaterial mit einer klaren, regel- bzw. gleichmäßig dreidimensional strukturierten Oberfläche, die Fig. 2 ein mögliches einfaches Schema des erfindungsgemäßen Verfahrens zur Herstellung eines Photovoltaik-Moduls mit den in Serie zu einer PV-Zelle zusammengeschalteten Photovoltaik-Einzelelementen, die Fig. 3 in einer Perspektivansicht ein erfindungsgemäß einzusetzendes Substratmaterial mit einer Oberfläche mit zwei gleichartigen Serien von regelmäßig dreidimensionalen Dreiecksprismen-Erhebungen, welche durch eine vergleichsweise erhöhte derartige Erhebung voneinander getrennt sind, wodurch eine Parallelschaltung von PV-ZellenPaketen ermöglicht wird, um eine ungefährliche, relativ niedrige Spannung jedes PV-Moduls sicherzustellen, die Fig. 4a und 4b schematisch eine Parallelschaltung der beiden Modul-Serien auf einem Substrat, die Fig. 5a bis 5d eine mögliche Art des erfindungsgemäßen PV-Zellen-Herstellungsverfahrens, zerlegt in die nacheinander erfolgenden Aufbringungsschritte des elektrisch leitfähigen Kontakt- und Verbindungsmaterials und des Materials für die stromliefernden Schichten der PV-Elemente, die Fig. 6 schematisch zwei gerichtete Materiegas- bzw. Druckflüssigkeitsstrahlen mit den real sich ausbildenden Strahlenkegeln, die Fig. 7 eine Anordnung der aufeinander folgenden Prozessschritte für eine kontinuierliche Herstellung von Dünnschichtsolarzellen, die Fig. 8a und 8b zwei Arten von pyramidal strukturierten Substrat-Oberflächen, die Fig. 9a und 9b zwei mögliche Arten der Belegung eines als dreidimensionales Raster von quadratischen Pyramiden ausgebildeten Substrates mit PV-Element-Teilflächen und die Fig. 10a und 10b zwei weitere mögliche Arten der Belegung von als dreidimensionales Raster von sechseckigen Pyramiden ausgebildeten Substrat-Oberflächen jeweils mit PV-Material.

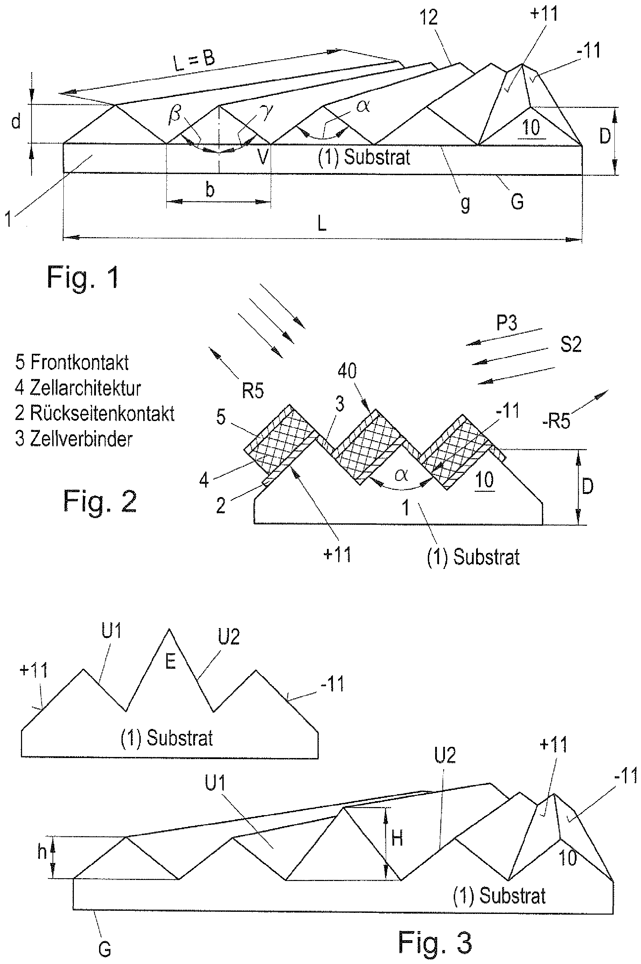

Das in Fig. 1 gezeigte plattenartige Substratmaterial 1 hat eine mit hier dreieckigen, sich längserstreckenden, zueinander parallelen Prismen 10 gebildete dreidimensionale Oberfläche O mit streifenförmigen, positiv ausgerichteten Prismenflächen +11 und streifenförmigen negativ ausgerichteten Prismenflächen -11, welche jeweils in einer gemeinsamen Kammkante bzw. in einem Kamm 12 enden. Der Kammwinkel α lässt sich durch eine Vertikale V zur Substratmaterial-Grundfläche G in die beiden - hier zueinander gleichen (oder verschiedenen) - Winkeln β und γ teilen, die gemeinsamen Grundlinien der Prismen 10 sind mit g, die Kammhöhe der einzelnen Prismen 10 ist mit d bezeichnet, deren Breite am Grund mit b. Der Abstand von der Substrat-Grundfläche G zum Prismenkamm 12 ist D, die Länge der Substratplatte 1, z.B. einer bzw. eines mit mehreren Einzel-PV-Elementen gebildeten PV-Zelle bzw. -Moduls ist L und dessen Breite B, die - wie hier angedeutet - gleich ist mit L.

Die Oberflächenstruktur besteht also hier aus jeweils geraden Verlauf aufweisenden, zeilenartig nebeneinander angeordneten dreieck-prismatischen Erhebungen 10. Die Erhebungen 10 können selbstverständlich auch anders, insbesondere asymmetrisch, geformt sein.

Die Höhe d und Breite b der Erhebungen können jeweils Dimensionen im Bereich von mm bis cm und die Länge L, die einem Vielfachen der jeweiligen Breite b der Prismen entspricht, ist z.B. typischerweise 50 cm für ein Freiflächenmodul, 70 cm für ein Fenster oder 100 cm für große Freiflächen-Module. Die Anzahl der Erhebungen 10 mal ihrer Breite b entspricht der Längsdimension L des Moduls , die typischerweise 1 m oder 1.5 m bei Freiflächenanwendungen und bis zu 3 m für Fenster beträgt.

Der Winkel a, den die Schenkel der Dreiecksspitze bzw. der freien Prismenkante bzw. des Prismenkamms 12 einnehmen, ist die Summe aus den Winkeln β und γ zwischen den beiden streifenartigen Seitenflächen +11 und -11 und der Senkrechten V auf die Grundfläche G des Substrates 1. Der Kamm-Winkel α ist typischerweise 90°. Zur Anwendung in verschiedenen Einbausituationen des Moduls kann dieser Winkel α jedoch jedenfalls zwischen 70 und 110° variieren.

Die Fig. 2 zeigt - bei sonst gleichbleibenden Bezugszeichenbedeutungen - in einer Skizze die wesentlichen Prozessschritte bei der Herstellung der erfindungsgemäßen Dünnschichtsolar- bzw. PV-Zellen. Die Abscheidung, also Bedampfung oder Bedruckung der Teilflächen +11, -11 auf dem Substrat 1 erfolgt in mehreren Schritten in numerischer Abfolge P2-P5 mittels jeweils die "richtige" Ausrichtung aufweisenden Materiedampf- oder Materieflüssigkeits-Strahlen S1 und S2 aus den Richtungen +R5 und -R5. Diese erfolgen jeweils unter einem entsprechenden Neigungswinkel pro Prozessschritt: jeweils für die Rückseitenkontakte 2, für die Zellarchitektur, also für die stromliefernden PV-Schichten 4, für die Frontkontakte 5 und unter einem anderen (negativen) Winkel für die Zellverbinder 3.

Weiters sind dort noch die streifenartigen negativen Teilbereichsflächen -11, des Prismen-Substrates 1 sowie die Oberfläche 40 der stromliefernden Schichten 4 jedes der PV-Elemente 15 eingezeichnet.

Das Substrat 1 besteht bevorzugterweise aus einem eisenarmen Solarglas mit der Gesamtdicke D. Dasselbe kann aber auch eine Metallfolie, ein Halbleiter, eine Keramik oder ein Kunststoff sein, mit einer strukturierten, also mit dreidimensionalen, regelmäßig angeordneten Erhebungen geformten Oberfläche.

Ist das Substrat eine Platte oder "Scheibe", durch welche zuerst das Licht durchgeht und erst dann auf die fertigen Solarzellen fällt, spricht man von "Superstratgeometrie".

Bildet das Substrat die Unterlage und das Licht fällt bloß durch eine transparente Verkapselung hindurch auf die PV-Zelle, so spricht man von "Substratgeometrie".

Die Rückseitenkontakte 2 sammeln die Ladungsträger auf der Rückseite der stromerzeugenden Schicht jeder einzelnen Solarzelle 4 und leiten sie über die Zellverbinder 3 jeweils zu den Frontseitenkontakten 5 der jeweils nächsten bzw. benachbarten stromerzeugenden Schicht 4.

Der Rückseitenkontakt 2 kann aus einem opaken Material, z.B. aus metallischem Silber bestehen, wenn das Licht von oben, also von der Seite der Frontkontakte 5 auf die einzelnen Solarzellen 4 fällt ("Substratgeometrie") oder aber aus einem leitenden transparenten Material, wie z.B. TCO's: beispielsweise Zinkoxid - ZnO - oder Indium-Zinnoxid - InsnO_{X} (ITO), Graphen, u. dgl., wenn das Licht durch ein Substratglas 1 ("Superstratgeometrie") auf die Solarzelle 4 fällt.

Die Zellverbinder 3 verbinden jeweils den Rückseitenkontakt 2 der Rückseite einer Zelle 4 mit dem Frontseitenkontakt 5 der Frontseite einer jeweils nachfolgenden PV-Zelle 4 usw. Dadurch wird eine elektrische Serienverschaltung erzielt. Die Zellverbinder 3 bilden photovoltaisch nicht-aktive Bereiche des mit den einzelnen photovoltaisch aktiven Schichten 4 mit ihren Kontakten 2, 5 und Verbindern 3 gebildeten Moduls. Die Zellverbinder 3 können aus einem opaken leitenden Material bestehen, oder aus einem transparenten elektrischen Leitermaterial.

Die Zellarchitektur selbst kann alle nach dem neuen Verfahren herstellbaren Dünnschicht-Solarzellen 4 bzw. 15 beinhalten. Die Herstellung derselben erfordert entweder mehrere gleichzeitige "Co-Depositionsschritte" oder aber aufeinanderfolgende Schritte zur jeweils "gerichteten" Material-Abscheidung, also zur Bedampfung oder Bedruckung zur Bildung der Zellarchitektur 2, 4, 5, 3 mittels mehrerer Abscheideeinrichtungen.

Es können mit dieser Methode prinzipiell alle Arten von Dünnschicht-Solar- bzw. PV-Zellen hergestellt werden, also z.B. Zellen mit amorphem Silizium, "a-Si", mit Cadmium-Tellurid "CdTe", mit Kupfer-Indium-Diselenid, mit CuInSe₂ ("CIS"), mit Kupfer-Indium-Gallium-Selenid, CuGaInSe_{X} ("CIGS"), usw.).

Hiezu sei zur Definition die Norm IEC/TS 61836 Ed.2: "Solar photovoltaic energy systems - Terms, definitions and symbols" genannt.

Die einzelnen Frontkontakte 5 können aus einem opaken leitenden Material bestehen, wenn das Licht durch das transparente Glas eines Substrates 1 (Superstratgeometrie) auf die einzelnen Solar- bzw. PV-Elemente fällt oder aber aus einem leitenden transparenten Material, wenn das Licht von der Seite der Frontkontakte 5 auf die einzelnen PV- bzw. Solarelemente 4 fällt (Substratgeometrie).

Die Modulgeometrie definiert die elektrischen Kenngrößen der Solarzellen und des Solarmoduls. Alle PV-Elementflächen einer PV-Zelle ergeben die Stromstärke I_{Z} in Ampere die eine Zelle liefern kann, d.h. I_{Z} ist proportional zu L und damit B, typischerweise in der Größenordnung von µA/cm² bis mA/cm².

Jeweils eine einzelne PV-Zelle entwickelt eine gewisse Spannung, die von der Art des jeweils eingesetzten Halbleiters abhängt, der die einzelnen photovoltaisch aktiven Schichten 4 bildet. Diese Spannung liegt typischerweise zwischen 0.3 V und 0.6 V.

Die einzelnen PV-Zellen werden direkt durch das erfindungsgemäße Herstellungsverfahren monolithisch verschaltet, also in Serie geschaltet.

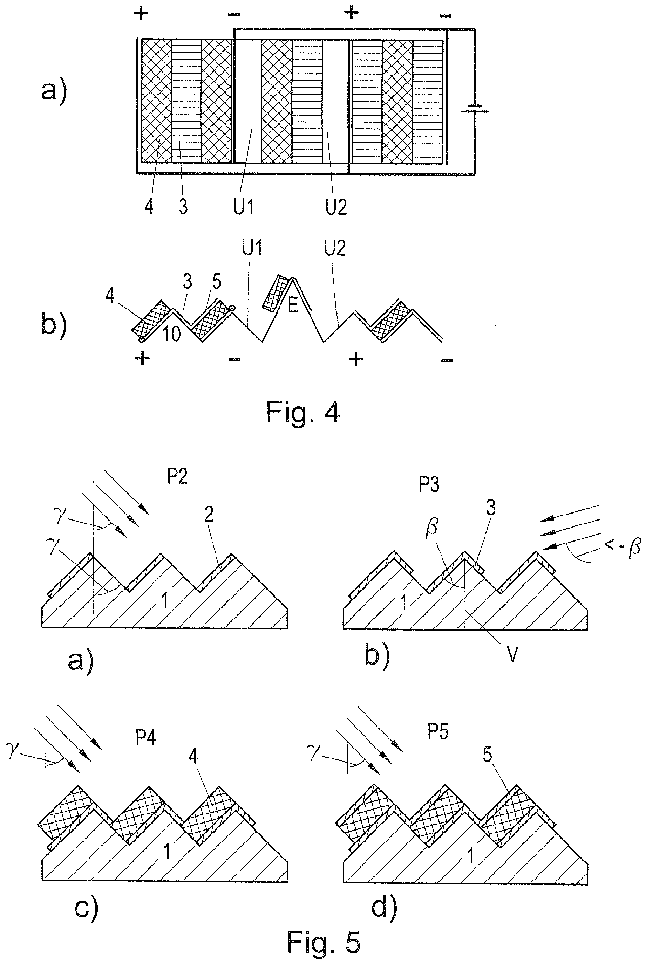

Damit entstehen bei relativ kleinen Strömen jedoch letztlich große Spannungen. Um für ein Modul die elektrischen Kennwerte besser einstellen zu können, kann man ein geeignet gewähltes Substrat 1 bedampfen oder bedrucken, wie es in den Fig. 3 sowie 4a und 4b - bei sonst gleichbleibenden Bezugszeichen - gezeigt ist:
Hier ist in regelmäßigen, jeweils geeignet gewählten Abständen eine erhöhte Erhebung E der strukturierten, d.h. mit dreidimensionalen, sonst regelmäßig dimensionierten und angeordneten, z.B. prismatischen, Erhebungen 10 geformten Oberfläche vorgesehen - und auf diese Weise lassen sich bei an sich *identem* Herstellungsprozess jeweils mehrere seriell verschaltete PV-Elemente bzw. -Zellen zu Blöcken parallel schalten. Damit erhöht man einerseits den Modul-Nennstrom, reduziert aber anderseits gleichzeitig die Modul-Nennspannung.

Beim Abscheidungsprozess mit der Folge der Schritte P2-P5 auf dem Substrat 1 - analog zur Vorgehensweise gemäß Fig. 2 - werden durch die höhere Prisma Erhebung E die Abscheidungen des Rückkontaktes 2, der Zellarchitektur 4 und des Frontkontaktes 5 auf dem jeweils nachfolgenden Prisma 10 im Abscheidungsschatten unterdrückt - Unterbrechung (U2), sowie die Abscheidung des Zellverbinders und der Zellverbinderfläche im Abscheideschatten unterdrückt - Unterbechung (U2). Damit ist die Serienschaltung unterbrochen. Wiederholt sich die Erhöhung E in regelmäßigen Abständen, so kann durch die Wiederholungsrate die Spannung und der Strom des mit den PV- bzw. Solarzellen gebildeten Moduls auf jeweils gewünschte, ungefährlich niedrige Werte eingestellt werden.

Z.B. ergeben sich bei exemplarischen Werten der Dünnschichtphotovoltaik von 0.4 V Zellspannung und 30 mA/cm² (bei Standard-Testbedingungen STC, siehe IEC/TS 61836 ed.2) für eine Modulgröße von L = 3 m Länge und B = 1 m Breite, einem Prismenkanten-Linienabstand b = 10 mm und einer Erhebungshöhe der Prismen von d = 4 mm eine Zellfläche von 0.71 cm × 100 cm = 71 cm² je Linie und einer solar inaktiven TCO-Fläche von ebenfalls 71 cm² und damit 2.13 A Kurzschlussstrom bei 0.4 V Leerlaufspannung einer Zelle. Eine Serienschaltung aller Zellen zu dem 3 m × 1 m Modul ergäbe sodann: 120 V.

Eine Verschaltung zu zwei Blöcken ergäbe z.B. 60 V und 4.26 A, siehe Schema der Fig. 4a. Die Verschaltung erfolgt durch die Unterbrechung der aktiven Zellfläche U2 in Prozessschritt P4 und der Zellverbinder U1 in Prozessschritt P3 jeweils durch den Schattenwurf der Erhöhung E.

Die Fig. 4a und 4b zeigen - bei sonst gleichbleibenden Bezugszeichenbedeutungen - dreidimensionale, regelmäßige dreieck-prismatische Erhebungen 10 auf der Oberfläche eines Substrates 1 und dazwischen die erhöhte Erhebung E und dadurch infolge Schattenwurfs während der Abscheidung unterbrochene Zellverbinder 3 - Unterbrechung U1 und unterbrochene Zellfläche 4 - Unterbrechung U2, um, wie in der Fig. 3a gezeigt, Parallelschaltung zu z.B. zwei Blöcken zu generieren.

Die Abscheidung der Verbinder- und Photovoltaik-Materialen kann durch die erfindungsgemäß vorgesehene, winkelmäßig gerichtete Bedampfung mittels bekannter, heute industriell gebräuchlicher Bedampfungsmethoden mit gerichtetem Materie-Dampfstrahl, wie z.B. mittels Sputtertechniken, Molekularstrahlepitaxie (MBE), physical vapour deposition (PVD), chemical vapour deposition (CVD), oder plasma enhanced chemical vapour deposition (PECVD) erfolgen. Weiters kann die Abscheidung durch selektives Drucken, also durch Schrägdruck oder durch Strahldruck erfolgen.

Die Fig. 5a bis 5d zeigen - bei sonst gleichbleibenden Bezugszeichenbedeutungen - im Einzelnen, wie die Bedampfung oder Bedruckung auf dem Substrat 1 erfolgt, nämlich in mehreren Schritten in numerischer Abfolge der Schritte P2-P5 und diese erfolgen jeweils unter einem entsprechenden Neigungswinkel je Prozessschritt, siehe hiezu auch das fertige Produkt in Fig. 2.

Die Neigungswinkel sind Idealerweise +γ für die Prozessschritte P2, P4 und P5, und kleiner als β für den Prozessschritt P3, jeweils gegen den Uhrzeigersinn von der Senkrechten V weg gerechnet, um einen jeweils perfekten Schattenwurf zu erzielen.

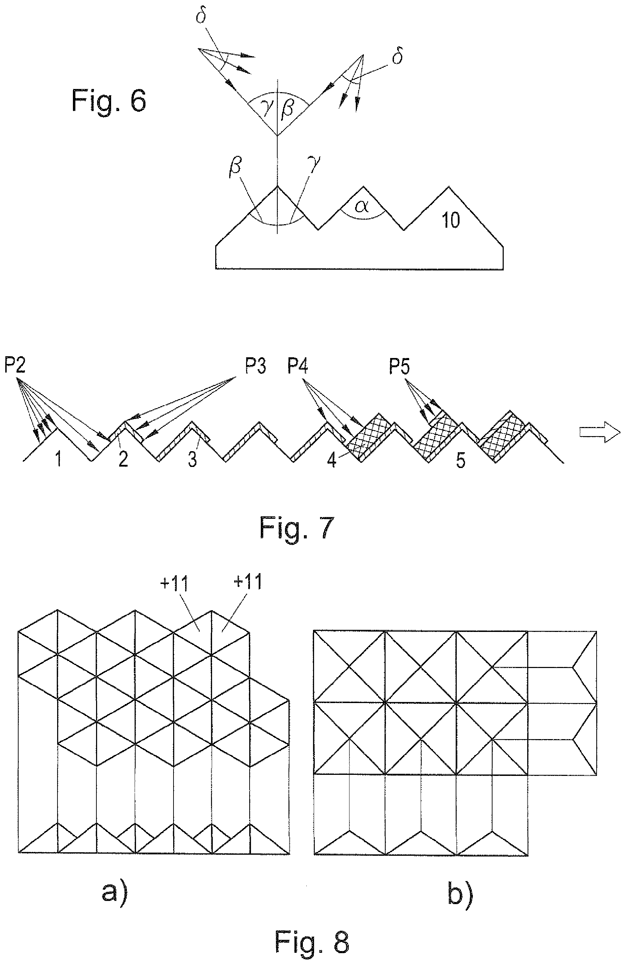

Die Fig. 6 zeigt - bei sonst gleichbleibenden Bezugszeichenbedeutungen - die konkreten Verhältnisse bei der Herstellung einer Dünnschicht-Solarzelle. Die Abscheidung durch gerichtete Bedampfung oder Bedruckung erfolgt unter einem jeweils entsprechenden Neigungswinkel, um jeweils einen perfekten Schattenwurf zu erzielen, und zwar unter Berücksichtigung der prozesstechnisch bedingten Strahldivergenz. Die Winkel variieren bei einer Strahldivergenz des Abscheideverfahrens δ um: +(γ+δ) für die Prozessschritte P2, P4 und P5 und -(γ-δ) für den Prozessschritt P3.

Die Fig. 7 erläutert - bei sonst gleichbleibenden Bezugszeichen - ein wie heute bevorzugtes progressives Produktionsverfahren gemäß der Erfindung:
Je nach Verfügbarkeit der Methode und der technischen Ausrüstung kann das gesamte Substrat 1 auf seiner gesamten Oberfläche jeweils einem adäquaten Prozessschritt P2-P5 ausgesetzt werden, wenn es in Ruhe bleibt, oder aber es kann auch in einer Prozessstraße linienförmig entlang der strukturierten, d.h. mit dreidimensionalen regelmäßigen Erhebungen geformten Oberfläche O des Substrates 1 jeweils in einer Richtung bedampft oder bedruckt werden, wenn es in Bewegung befindlich ist.

Dabei ist es möglich, mit dem jeweils nächsten Prozessschritt P3-P5 an einem Ende des Substrates 1 zu beginnen, bevor der vorhergehende Prozessschritt P2-P5 das entgegengesetzte Ende des Substrates 1 erreicht hat.

Die Abscheidung der verschiedenen Materialien kann dabei linienförmig durch Strahl-Schlitze oder punktförmig durch mehrere, entlang der Breite jedes einzelnen Photovoltaikelementes nebeneinander angeordnete Strahl-Düsen oder Düsenköpfe erfolgen.

Die Abscheidungsschritte P2-P5 können dabei je Modullänge L hintereinander erfolgen, also der jeweils folgende Schritt erst, wenn der jeweils vorhergehende Schritt für das ganze Modul abgeschlossen ist oder innerhalb der Modullänge L gleichzeitig der jeweils folgende Schritt bereits dann, wenn der jeweils vorhergehende Schritt noch nicht für das ganze Modul durchgeführt worden ist.

Was die verschiedenen Möglichkeiten des Einsatzes der neuen Photovoltaikzellen bzw. -Module betrifft, so ist hiezu folgendes auszuführen:
Das aus den PV-Zellen monolithisch oder durch Block-Parallelschaltung gebildete PV-Modul kann in verschiedenen Anwendungen zum Einsatz kommen:
Es kann beispielsweise
(a) in einer Fassade als semitransparentes Element eingesetzt werden. Dabei kann man die Abschattungsgrade durch Wahl der Winkel β und γ und die Längen der Prismen-Dreiecksseiten wählen:
   geringe Abschattung mit β << 45° undγ =45° d < 5 mm und b > 1 cm,
   50%-Abschattung mit β = 45° undγ =45°, d = 5mm und b = 1 cm,
   50%-Abschattung und homogenes Erscheinungsbild mit β = 45° undγ =45°, d = 1 mm und b = 2 mm, oder
   hohe Verschattungsgrade mit β = 45° undγ =45° d = 5 mm und b > 1 cm.
(b) als verschattendes Dachelement mit β = γ oder
(c) als Freiflächenmodul, z.B. mit β > γ, b>>d bei Südorientierung eingesetzt werden, wie im Detail in der simultanen Patentanmeldung "Fenster- bzw. Fassaden" beschrieben.

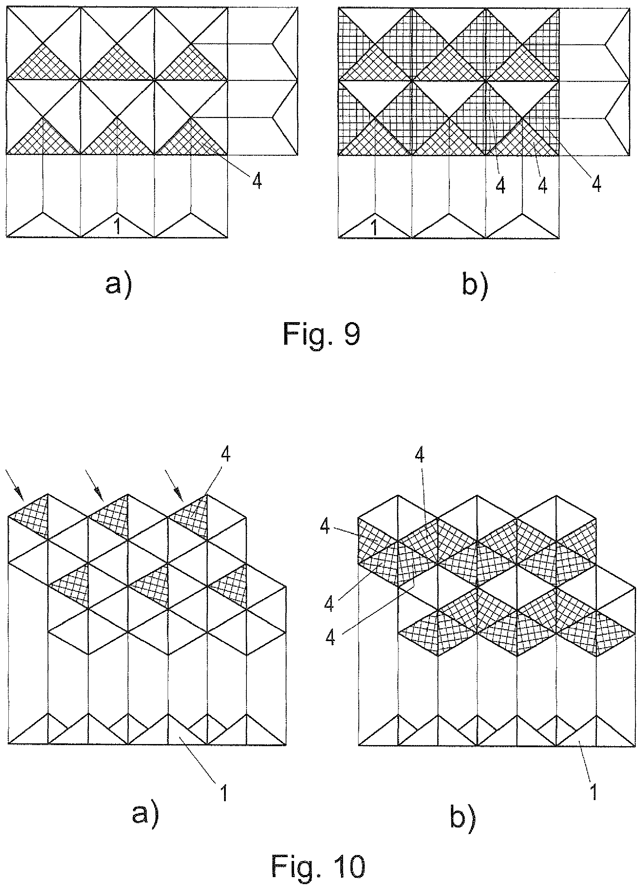

Andere Substrate und PV-Module mit alternativen Strukturierungen zeigen - bei sonst gleichbleibenden Bezugszeichenbedeutungen - die Fig. 8a und 8b sowie die Fig. 9a und 9b.

Es ist möglich, den erfindungsgemäßen Prozess zur Herstellung von monolithisch verschalteten photovoltaischen Dünnschichtzellen bzw. derartiger Module ausschließlich durch gerichtete Abscheidung auf einer strukturierten Oberfläche auch auf Oberflächen von Substraten mit einer anderen als der vorstehend beispielhaft angegebenen, regelmäßigen dreiecks-prismatischen 3D-Struktur durchzuführen.

Als Beispiele seien eine rasterartige Vierseiten-Pyramiden- und eine hexagonale Pyramidenstruktur genannt.

Der erfindungsgemäße Herstellungsprozess ist insbesondere auf allen jenen regelmäßigen dreidimensionalen Strukturen möglich, die eine sich wiederholende Symmetrie aufweisen, welche eine Definition der Winkel β und γ sowie der Strukturerhebungshöhe d erlauben und die damit durch die Prozessschritte P1 bzw. P2 bis P5 die Herstellung einer monolithisch verschalteten photovoltaischen Dünnschichtzelle (bzw. eines dieselben umfassenden Moduls) ausschließlich durch gerichtete Abscheidung auf der strukturierten Oberfläche eines Substrates ermöglichen.

Zweidimensional strukturierte Oberflächen weisen gegenüber eindimensional strukturierten Oberflächen, also z.B. gegenüber geradlinien-prismenförmigen, wie sie weiter vorne beschrieben sind, den Vorteil auf, dass die Prozessschritte P1 bis P5 zu einer zweidimensionalen Verschaltung des Photovoltaikmodules genutzt werden können.

Damit wird es leichter, verschiedene Serien- und Parallelschaltungen zu erzeugen und Ertragsminderungen bei Verschattungsfällen am Einbauort zu minimieren (Matrixschaltung) sowie die Richtungsabhängigkeit der Einstrahlung zu berücksichtigen oder eine größere Toleranz gegenüber verschiedenen, gegebenenfalls extremen, Einstrahlungswinkeln zu erreichen.

Eine mögliche Belegung von zwei geeigneten Oberflächen-Strukturen des Substrates mit Photovoltaikmaterial 4 ist - bei sonst gleichbleibenden Bezugszeichenbedeutungen - beispielhaft in den Fig. 10a und 10b gezeigt.

## Patentansprüche

1. Verfahren zur Herstellung - von mit untereinander in jeweils gewünschter oder technisch bedingter Weise verschalteten Einzel-Dünnschicht-Photovoltaikelementen gebildeten - Photovoltaikzellen bzw. -modulen durch gerichtete Abscheidung der zur Bildung der eben genannten Einzelphotovoltaikelemente einzusetzenden Materialien, **dadurch gekennzeichnet,**
- **dass** - unter kontinuierlicher Aufrechterhaltung einer jeweils vorgesehenen Gasatmosphäre oder eines Vakuums bzw. Unterdrucks während des gesamten Herstellungs- bzw. Abscheidungsprozesses, also unter Vermeidung von Aussetzperioden -
a) auf eine große Zahl von, nach einer oder mehr als einer, vorzugsweise einheitlichen, Richtung(en) (+R5) hin ausgerichteten, positiven Teilbereichsflächen (+11) einer drei-dimensional strukturierten Oberfläche (O) eines plattenförmigen, vorzugsweise elektrisch nicht leitenden, Substratmaterials (1) unter strukturell bedingter Abschattung der jeweils die genannten positiven Teilbereichsflächen (+11) verbindenden und in entgegengesetzter Richtung (-R5) ausgerichteten, negativen Verbindungs-Teilbereichsflächen (-11) unter einem, gegebenenfalls rechten, Winkel (a) ein Materiegas- oder Flüssigkeitsdruckstrahl oder -strom (S1) aus einem Elektro-Kontaktmaterial zur Bildung bzw. Abscheidung der Rückseiten-Kontakte (2) der Einzel-Photovoltaikelemente (15) gerichtet wird,
b) **dass** auf die bzw. auf einen oberen Bereich der gemäß a) genannten abgeschatteten - in anderer oder in entgegengesetzter Richtung als die unter a) genannten Teilbereichsflächen (+11) in Richtung (-R5) ausgerichteten - Verbindungs-Teilbereichsflächen (-11) unter einem Winkel (-β), gegebenenfalls >90°, ein Materiegas- oder Flüssigkeitsdruckstrahl (S2) eines, gegebenenfalls dem Elektro-Kontaktmaterial gemäß a) gleichen, Elektro-Kontaktmaterials unter Abscheidung - von die unter a) genannten Rückseiten-Kontakte (2) miteinander elektrisch verbindenden, stromleitenden Zell-Verbindern (3) aufgebracht wird,
c) **dass** dann unter (Wieder-)Einstellung der unter a) eingehaltenen Materiegas- oder Flüssigkeitsdruckstrahl- oder -stromrichtung (+R5) auf den - auf den wie unter a) genannten Teilbereichsflächen (+11) abgeschiedenen - Rückseitenkontakten (2), mittels anders, also unterschiedlich, beaufschlagter Materiegas- oder Flüssigkeitsdruckstrahl oder -ströme eine jeweils für die Bildung der stromliefernden photovoltaisch aktiven Schichten (4) der Einzel-Photovoltaikelemente (15) vorgesehene Zell-Architektur aufgebracht bzw. abgeschieden wird, und
d) **dass** schließlich unter Beibehaltung der unter a) oder c) genannten Materiegas- oder Flüssigkeitsdruckstrahl- oder -strom-Richtung (+R5) auf die Außenflächen (40) der unter c) genannten photovoltaisch aktiven Schichten (4) der Einzel-Photovoltaikelemente (15) jeweils unter Anbindung an die mit den gemäß a) abgeschiedenen Rückseitenkontakten (2) elektrisch verbundenen Zellverbinder (3) - ein Materiegas- oder Flüssigkeitsdruckstrahl oder -strom aus einem für die Bildung bzw. Abscheidung der Frontkontakte (5) vorgesehenen Elektro-Kontaktmaterial der Einzel-Photovoltaikelemente (15) gerichtet wird.

2. Verfahren nach Anspruch 1, **dadurch gekennzeichnet, dass** als dreidimensional strukturiertes Substratmaterial ein solches eingesetzt wird, dessen Oberfläche mit zueinander parallel angeordneten und zueinander parallel ausgerichtete Kämme (12) und zwischen einander zueinander parallele Täler aufweisenden Dreiecksprismen ausgebildet sind, und dass auf deren alle den gleichen positiven Neigungs-Winkel zur Substraterstreckung aufweisenden zueinander ebenfalls parallel verlaufenden bandartigen, die positiven Teilbereichsflächen (+11) bildenden Seitenflächen selbst gemäß a) bzw. auf die auf die Außenflächen (40) der auf die soeben genannte Flächen (+10) gemäß c) aufgebrachten photovoltaisch aktiven Schichten der Einzel-Photovoltaikelemente (4) gemäß d) mittels Materiegas- oder Flüssigkeitsdruckstrahl das Elektrokontaktmaterial aufgebracht wird und dass gemäß b) auf die kamm-nahen bis zu den Prismenkämmen (12) reichenden bandartigen Teilbereiche der ebenfalls zueinander parallel verlaufenden negativen Teilbereichsflächen (-11) ebenfalls mittels Materiegas- oder Flüssigkeitsdruckstrahl das Elektrokontaktmaterial aufgebracht ist.

3. Verfahren nach Anspruch 1 oder 2, **dadurch gekennzeichnet, dass** ein Substratmaterial (1) eingesetzt wird, dessen Oberfläche (O) mit untereinander gleiche Dimension besitzenden, gleichseitigen Dreiecks-Querschnitt aufweisenden Dreiecksprismen (10) als Erhebungen ausgebildet ist.

4. Verfahren nach Anspruch 1 oder 2, **dadurch gekennzeichnet, dass** ein Substratmaterial (1) eingesetzt wird, dessen Oberfläche (O) mit untereinander gleiche Dimension besitzenden, verschieden-seitigen Dreiecks-Querschnitt aufweisenden Dreiecksprismen (10) als Erhebungen ausgebildet ist.

5. Verfahren nach einem der Ansprüche 1 bis 3, **dadurch gekennzeichnet, dass** ein Substratmaterial (1) eingesetzt wird, dessen die Erhebungen der Oberfläche (O) bildenden Dreiecksprismen (10) jeweils einen Kammwinkel (a) von 60 bis 120°, insbesondere von 80 bis 100°, aufweisen.

6. Verfahren nach einem der Ansprüche 1 bis 4, **dadurch gekennzeichnet, dass** ein Substratmaterial (1) eingesetzt wird, dessen die Erhebungen der Oberfläche (O) bildenden Dreiecksprismen (10) positive Seitenflächen bzw. Teilbereichsflächen (+11) zur Erstreckung des Substratmaterials zwischen +90 und +15°, insbesondere zwischen +75 und +30°, bzw. desen negative Seitenflächen bzw. Teilbereichsflächen (-11) zur Erstreckung (G) des Substrates (1) zwischen -90 und -15° insbesondere zwischen -75 und -30°, geneigt sind.

7. Verfahren nach einem der Ansprüche 1 bis 5, **dadurch gekennzeichnet, dass** ein Substratmaterial (1) eingesetzt wird, dessen die Erhebungen der Oberfläche (O) bildenden Dreiecksprismen (10) zylindermantelflächig abgerundete Kämme (12) aufweisen.

8. Verfahren nach einem der Ansprüche 1 bis 6, **dadurch gekennzeichnet, dass** ein Substratmaterial (1) eingesetzt wird, dessen Oberfläche (O) mit einer Mehrzahl von jeweils, bevorzugt gleiche Anzahl von, zueinander parallel verlaufenden Dreiecksprismen (10) untereinander gleicher Dimension, insbesondere gleicher Prismenhöhe (H), aufweisenden Serien bzw. Paketen von Dreiecksprismen ausgebildet ist, die jeweils voneinander durch Dreiecksprismen (E) mit größerer Dimension, insbesondere größerer Prismenhöhe (H), getrennt sind.

9. Verfahren nach einem der Ansprüche 1 bis 7, **dadurch gekennzeichnet, dass** ein Substratmaterial (1) eingesetzt wird, dessen Oberfläche (O) mit untereinander gleiche Dimension besitzenden rasterartig angeordneten, aneinandergrenzenden vier- oder sechsseitigen Pyramiden ausgebildet ist, wobei analog zur Schrittfolge a) bis d) gemäß Anspruch1,
a) zuerst auf die 2 oder 3 positiv angeordneten Pyramidenflächen (+11a, +11b; +11c) mittels gasförmigem Materie- oder flüssigdispersem Druckstrahl ein Rückseiten(2)-Elektrokontaktmaterial aufgebracht wird,
b) auf die spitzennahen, oberen Bereiche der negativen Pyramidenflächen (-11a, -11b; - 11c) und unter Ausschluss der unteren Bereiche derselben in gleicher Weise wie gemäß a) ebenfalls ein Elektrokontakt-Verbindungs(3)-Material aufgebracht wird,
c) dann - analog zu Schritt c) des Anspruches 1 - wieder auf die mit Rückseiten(2)-Elektrokontaktmaterial beaufschlagten positiv angeordneten Pyramidenflächen (+11a, +11b; +11c) das photovoltaisch aktive Material (4) und
d) auf dasselbe - analog zu Schritt d) des Anspruches 1 - das Frontseiten(5)-Elektrokontaktmaterial auf das photovoltaisch aktive Material (4) der positiven Pyramidenflächen (+11a, +11b; +11c) und auf die nach oben weisende Schmal- bzw. Stirnseite des Verbindungs(3)-Elektrokontaktmaterials in den spitzen-nahen Bereichen der negativen Pyramidenflächen (-11a, -11b; -11c) aufgebracht wird.

## Claims

1. A method for the production of photovoltaic cells or modules formed of individual thin-film photovoltaic elements being mutually interconnected in a respectively desired or technically required manner by means of the directed deposition of the materials used for the formation of the aforementioned individual photovoltaic elements, **characterised in that** - with continual maintenance of a respectively provided gaseous atmosphere or a vacuum or low pressure during the entire production or deposition process, i.e. by avoiding suspension periods -
a) a gas or liquid pressurised jet or flow (S1) is directed from an electric contact material onto a large number of positive sub-region surfaces (+11), said positive sub-region surfaces being oriented towards one or more than one, preferably uniform, direction(s) (+R5), of a three-dimensionally structured surface (O) of a plate-shaped, preferably electrically non-conductive, substrate material (1) while shading in a structural nature the negative connecting sub-region surfaces (-11), said negatively connecting sub-region surfaces connecting said positively oriented sub-region surfaces (+11) and being oriented in the opposite direction (-R5), at a, possibly right, angle (α), in order to form or deposit the rear-face contacts (2) of the individual photovoltaic elements (15),
b) that a gas or liquid pressurised jet (S2) of an electric contact material, being possibly equal to the electric contact material according to a), is applied to the or to an upper area of the shaded connecting sub-region surfaces (-11) being oriented - in another or in the opposite direction to the sub-region surfaces (+11) stated in a) that are oriented in direction (-R5)-, at an angle (-β), possibly >90°, thereby depositing conductive cell connectors (3) - electrically connecting said rear-face contacts (2) stated in a)
c) that a cell architecture being provided respectively for the formation of the current-supplying photovoltaically active layers (4) of the individual photovoltaic elements (15) is then applied to or deposited, while (re)adjusting the gas or liquid pressurised jet or flow direction (+R5) being maintained in a), on the rear-face contacts (2) - being deposited on the sub-region surfaces (+11) as stated in a), by means of other, i.e. different, impinged gas or liquid pressurised jet or flows, and
d) that finally, while maintaining the gas or liquid pressurised jet or flow direction (+R5) stated in a) or c), a gas or liquid pressurised jet or flow is directed from an electric contact material, provided for the formation or deposition of the front contacts (5), of the individual photovoltaic elements (15), respectively onto the external surfaces (40) of the photovoltaically active layers (4), stated in c), of the individual photovoltaic elements (15), thereby connecting with the cell connectors (3) being electrically connected with the rear-face contacts (2) deposited according to a).

2. The method according to claim 1, **characterised in that** as a three-dimensionally structured substrate material, such a material is used, the surface of which is formed with mutually parallel arranged and mutually parallel oriented ridges (12) and triangular prisms having mutually parallel troughs therebetween, and that the electric contact material is applied by means of a gas or liquid pressurised jet onto the lateral surfaces themselves according to a), said lateral surfaces all having the same positive angle of inclination to the substrate extension, also running parallel to one another in a band-like manner and forming the positive sub-region surfaces (+11) or onto the external surfaces (40) of the photovoltaically active layers of the individual photovoltaic elements (4) according to d) being applied to the just mentioned surfaces (+10) according to c) and that according to b) the electric contact material is also applied by means of gas or liquid pressurised jet onto the band-like sub-regions extending from near the ridge to the prism ridges (12) of the negative sub-region surfaces (-11) also running parallel to one another.

3. The method according to claim 1 or 2, **characterised in that** a substrate material (1) is used, the surface (O) of which is formed with triangular prisms (10), having identical dimensions having equilateral triangle profiles, as elevations.

4. The method according to claim 1 or 2, **characterised in that** a substrate material (1) is used, the surface (O) of which is formed with triangular prisms (10), having identical dimensions having non-equilateral triangle profiles, as elevations.

5. The method according to one of claims 1 to 3, **characterised in that** a substrate material (1) is used, the triangular prisms (10) of which forming the elevations of the surface (O) each have a ridge angle (α) of 60 to 120 °, particularly 80 to 100 °.

6. The method according to one of claims 1 to 4, **characterised in that** a substrate material (1) is used, towards whose triangular prisms (10) forming the elevations of the surface (O) are inclined positive lateral surfaces or sub-region surfaces (+11) to extend the substrate material between +90 and +15°, particularly between +75 and +30°, and towards which are inclined negative lateral surfaces or sub-region surfaces (-11) to extend (G) the substrate (1) between -90 and -15°, particularly between -75 and -30°.

7. The method according to one of claims 1 to 5, **characterised in that** a substrate material (1) is used, the triangular prisms (10) of which forming the elevations of the surface (O) have ridges (12) being rounded on the cylindrical outer surface.

8. The method according to one of claims 1 to 6, **characterised in that** a substrate material (1) is used, the surface (O) of which is formed with a multitude of series or packets of triangular prisms, each having preferably the same number of triangular prisms (10) running parallel to one another, said triangular prisms having mutually identical dimensions, particularly identical prism height (H), which are separated from one another by triangular prisms (E) with greater dimensions, particularly greater prism height (H).

9. The method according to claim 1 or 7, **characterised in that** a substrate material (1) is used, the surface (O) of which is formed with four-sided or six-sided pyramids being arranged adjacently to one another in a grid-like manner and having mutually identical dimensions, wherein in a similar manner to the series of steps a) to d) according to claim 1,
a) first a rear-face (2) electric contact material is applied to the 2 or 3 positively arranged pyramid surfaces (+11a, +11b; +11c) by means of a gaseous material or liquid dispersion pressurised jet,
b) an electric contact connecting (3) material is also applied to the upper areas of the negative pyramid surfaces (-11a, -11b; -11c) being close to the peak and to the exclusion of the lower areas of said negative pyramid surfaces in the same way as according to a),
c) then - similarly to step c) of claim 1 - the photovoltaically active material (4) is applied again to the pyramid surfaces (+11a, +11b; +11c) being positively impinged with rear-face (2) electric contact material and
d) on the same - similarly to step d) of claim 1 - the front side (5) electric contact material is applied to the photovoltaically active material (4) of the positive pyramid surfaces (+11a, +11b; +11c) and on the upwardly pointing narrow face or end face of the connecting (3) electric contact material in the areas of the negative pyramid surfaces (-11a, -11b; -11c) being close to the peak.

## Revendications

1. Procédé de fabrication de cellules ou modules photovoltaïques constitués d'éléments photovoltaïques simples en couche mince reliés les uns aux autres de manière respectivement souhaitée ou liée aux contraintes techniques, par dépôt dirigé des matériaux à utiliser pour la formation desdits éléments photovoltaïques simples, **caractérisé en ce**
- **que**, en maintenant de façon continue un vide, une pression négative ou une atmosphère gazeuse respective prédéfini pendant l'ensemble du processus de dépôt ou de fabrication et en évitant également les périodes d'exposition,
a) un flux ou jet sous pression de fluide ou de matière gazeuse (S1) à partir d'un matériau de contact électrique est orienté dirigé selon un angle (α), le cas échéant droit, pour la formation ou le dépôt de contacts de côté arrière (2) des éléments photovoltaïques simples (15) sur un grand nombre de surfaces partielles positives (+11) orientées dans une ou plusieurs, de préférence unitaires, directions (+R5) d'une surface (O) à structure tridimensionnelle d'un matériau de substrat (1) en forme de plaque, de préférence non électroconducteur, en ombrageant les surfaces partielles négatives (-11) de liaison reliant les surfaces partielles positives (+11) susmentionnées, orientées dans une direction opposée (-R5),
b) en ce que, sur la ou sur une zone supérieure des surfaces partielles de liaison (-11) mentionnées en a) ombragées - orientées dans une autre direction ou dans la direction opposée aux surfaces partielles (+11) mentionnées en a) dans la direction (-R5), un jet sous pression de fluide ou de matière gazeuse (S2) d'un matériau de contact électrique, le cas échéant identique au matériau de contact électrique selon a), est appliqué selon un angle (-β), le cas échéant >90°, par dépôt - parmi les connecteurs de cellules (3) électroconducteurs, reliant électriquement les uns aux autres les contacts de côté arrière (2) mentionnés en a),
c) en ce que, ensuite, avec un (nouveau) réglage de la direction de flux ou de jet sous pression de fluide ou de matière gazeuse (+R5) mentionné en a), une architecture de cellule conçue pour la formation des couches (4) à action photovoltaïque conductrices de courant des éléments photovoltaïques simples (15) est appliquée ou déposée sur les contacts de côté arrière (2) - déposés sur les surfaces partielles (+11) mentionnées en a) - au moyen d'un autre, à savoir différent, flux ou jet sous pression de fluide ou de matière gazeuse et
d) en ce que, enfin, en maintenant la direction (+R5) de flux ou de jet sous pression de fluide ou de matière gazeuse mentionné en a) ou c) un flux ou jet sous pression de fluide ou de matière gazeuse est dirigé sur les surfaces externes (40) des couches (4) à action photovoltaïque mentionnées en c) des éléments photovoltaïques simples (15) respectivement par liaison avec les connecteurs de cellules (3) reliant électriquement les contacts de côté arrière (2) ombragés selon a) pour la formation ou le dépôt des contacts avant (5) du matériau de contact électrique des éléments photovoltaïques simples (15).

2. Procédé selon la revendication 1, **caractérisé en ce que**, en guise de matériau de substrat à structure tridimensionnelle, un tel matériau est utilisé, dont les surfaces sont conçues avec des prismes triangulaires présentant des crêtes (12) disposées parallèles les unes aux et orientées de manière parallèle les unes par rapport aux autres et des creux parallèles les uns aux autres et **en ce que** le matériau de contact électrique est appliqué sur ses surfaces latérales formant les surfaces partielles positives (+11) en forme de bandes s'étendant également parallèlement les unes aux autres présentant toutes le même angle d'inclinaison positif par rapport à l'extension du substrat comme selon a) ou sur les couches à action photovoltaïque des éléments photovoltaïques simples (4) selon d) appliquées sur les surfaces externes (40) desdites surfaces (+10) mentionnées selon c) au moyen d'un jet sous pression de fluide ou de matière gazeuse et **en ce que**, selon b) le matériau de contact électrique est appliqué sur les zones partielles en forme de bandes atteignant les crêtes de prisme (12) à proximité des crêtes des surfaces partielles (-11) négatives s'étendant parallèles les unes aux autres également au moyen d'un jet sous pression de fluide ou de matière gazeuse.

3. Procédé selon la revendication 1 ou 2, **caractérisé en ce qu'**un matériau de substrat (1) est utilisé, dont la surface (O) est constituée de prismes triangulaires (10) en guise de bosses, présentant une section transversale triangulaire équilatérale possédant des dimensions identiques les uns aux autres.

4. Procédé selon la revendication 1 ou 2, **caractérisé en ce qu'**un matériau de substrat (1) est utilisé, dont la surface (O) est constituée de prismes triangulaires (10) en guise de bosses, présentant une section transversale triangulaire de côtés différents possédant des dimensions identiques les uns aux autres.

5. Procédé selon une des revendications 1 à 3, **caractérisé en ce qu'**un matériau de substrat (1) est utilisé, dont les bosses des prismes triangulaires (10) formant la surface (O) présentent respectivement un angle de crête (α) de 60 à 120°, en particulier de 80 à 100°.

6. Procédé selon une des revendications 1 à 4, **caractérisé en ce qu'**un matériau de substrat (1) est utilisé, dont les surfaces latérales ou surfaces partielles positives (+11) des bosses des prismes triangulaires (10) formant la surface (O) sont inclinées par rapport à l'extension du matériau de substrat d'entre +90 et +15°, en particulier entre +75 et +30° ou dont les surfaces partielles ou surfaces latérales négatives (-11) sont inclinées par rapport à l'extension (G) du substrat (1) d'entre -90 et -15° en particulier entre -75 et -30°.

7. Procédé selon une des revendications 1 à 5, **caractérisé en ce qu'**un matériau de substrat (1) est utilisé, dont les bosses des prismes triangulaires (10) formant la surface (O) présentent des crêtes (12) arrondies en forme d'enveloppe cylindrique pleine.

8. Procédé selon une des revendications 1 à 6, **caractérisé en ce qu'**un substrat de matériau (1) est utilisé, dont la surface (O) est formée d'une pluralité de séries ou de lots de prismes triangulaires présentant de préférence un nombre identique de prismes triangulaires (10) s'étendant parallèles les uns aux autres et ayant des dimensions identiques, notamment des hauteurs de prisme identiques (H), qui sont séparés les uns des autres respectivement par des prismes triangulaires (E) ayant une dimension supérieure, notamment une hauteur de prisme supérieure (H).

9. Procédé selon une des revendications 1 à 7, **caractérisé en ce qu'**un matériau de substrat (1) est utilisé, dont la surface (O) est constituée de pyramides à quatre ou six côtés adjacents les unes aux autres, disposées sous forme de réseau et possédant des dimensions égales les unes aux autres, dans lequel, de manière analogue à la suite d'étapes a) à d) selon la revendication 1,
a) d'abord, un matériau de contact électrique de côté arrière (2) est appliqué sur les 2 ou 3 surfaces de pyramide (+11a, +11b ; +11c) disposées de manière positive au moyen d'un jet sous pression dispersé de fluide ou de matière gazeuse,
b) un matériau de liaison de contact électrique (3) est appliqué sur les zones supérieures proches de la pointe des surfaces de pyramide (-11a, -11b ; -11c) négatives et à l'exclusion des zones inférieures de celles-ci de la même manière que conformément à a) également,
c) ensuite, de manière analogue à l'étape c) de la revendication 1, le matériau à action photovoltaïque (4) est appliqué de nouveau sur les surfaces de pyramide (+11a, +11b ; +11c) disposées de manière positive recevant le matériau de contact électrique de côté arrière (2) et
d) sur celles-ci, de manière analogue à l'étape d) de la revendication 1 le matériau de contact électrique de côté avant (5) est appliqué sur le matériau à action photovoltaïque (4) des surfaces de pyramide (+11a, +11b ; +11c) positives et sur le côté avant ou étroit faisant saillie vers le haut du matériau de contact électrique de liaison (3) dans les zones proches de la pointe des surfaces de pyramide (-11a, -11b ; -11c) négatives.
